# EUROPEAN PATENT APPLICATION

(11) **EP 4 535 431 A1**
(43) Date of publication of application: **09.04.2025**
(21) Application number: 23814633.6
(22) Date of filing: 31.01.2023
(51) Int. Cl.: H01L 31/0747, H01L 31/0224, H01L 31/20

(54) **SOLAR CELL AND PREPARATION METHOD, AND POWER GENERATION DEVICE**

(30) Priority: 30.05.2022 CN 202210599711
(71) Applicant: Tongwei Solar (Jintang) Co., Ltd., Chengdu City Sichuan 610400 (CN)
(72) Inventor: CHEN, Zhou, Chengdu, Sichuan 610299 (CN)
(74) Representative: Michalski Hüttermann & Partner Patentanwälte mbB
(86) International application number: PCT/CN2023/073936
(87) International publication number: WO 2023/231434

(57) **Abstract**

The present application provides a heterojunction solar cell, including a cell substrate (100) and a conductive layer. The conductive layer includes a first transparent conductive film (210), a silver electrode (220), and a second transparent conductive film (230). The first transparent conductive film (210) is disposed on a surface of the cell substrate (100), the silver electrode (220) is disposed on a partial region of the first transparent conductive film (210), and the second transparent conductive film (230) covers the silver electrode (220) and the first transparent conductive film (210).

## Description

### CROSS-REFERENCE TO RELATED APPLICATION

This application claims the priority of Chinese Patent Application No. 202210599711X, filed with the Chinese Patent Office on May 30, 2022 and entitled "SOLAR CELL AND PREPARATION METHOD, AND POWER GENERATION DEVICE", which is incorporated in its entirety herein by reference.

### TECHNICAL FIELD

The present application relates to the technical field of solar cells, in particular to a solar cell, a preparation method, and a power generation device.

### BACKGROUND

Heterojunction solar cells are a special type of PN junction, typically composed of both amorphous and crystalline silicon materials. The heterojunction solar cells offer advantages such as high efficiency and high open-circuit voltage, making them promising candidates for various applications.

The manufacturing process for the heterojunction solar cells generally involves several steps, including texturing, amorphous silicon deposition, transparent conductive layer deposition, and grid electrode screen-printing. The process temperature for these procedures typically does not exceed 400°C. Silver, known for its highest electrical conductivity among metals, is commonly used as a material of the electrodes. In practice, the raw materials for the electrodes includes high-temperature and low-temperature silver pastes. While the high-temperature silver paste provides good conductivity, it requires shaping at temperatures above 700°C, which can significantly damage the film of the heterojunction solar cell. Consequently, the gate electrodes of the heterojunction solar cells are usually prepared using low-temperature silver paste. The low-temperature silver paste contains spherical and flaky silver powder along with an organic resin for bonding. Unlike the high-temperature silver paste, which is formed through melting and sintering, the low-temperature silver paste bonds silver powder particles together using resin, and the entire electrode is also adhered to the transparent conductive film via resin, leading to increased line resistance of the electrode and higher contact resistance between the electrode and the transparent conductive film. These factors significantly impact the efficiency of the heterojunction solar cells.

### SUMMARY

According to some embodiments of the present application, a solar cell is provided. The solar cell includes a cell substrate and a conductive layer. The conductive layer includes a first transparent conductive film, a silver electrode, and a second transparent conductive film. The first transparent conductive film is disposed on a surface of the cell substrate, the silver electrode is disposed on a partial region of the first transparent conductive film, and the second transparent conductive film covers the silver electrode and the first transparent conductive film.

In some embodiments of the present application, a total thickness of the first transparent conductive film and the second transparent conductive film is 70 nm to 100 nm.

In some embodiments of the present application, the first transparent conductive film has a thickness greater than that of the second transparent conductive film.

In some embodiments of the present application, the first transparent conductive film has a thickness of 50 nm to 70 nm.

In some embodiments of the present application, the second transparent conductive film has a thickness of 10 nm to 30 nm.

In some embodiments of the present application, the cell substrate includes a silicon substrate layer, an intrinsic amorphous silicon layer, and a doped amorphous silicon layer. The intrinsic amorphous silicon layer is disposed on the silicon substrate layer, the doped amorphous silicon layer is disposed on a surface of the intrinsic amorphous silicon layer away from the silicon substrate layer, and the first transparent conductive film is disposed on a surface of the doped amorphous silicon layer away from the intrinsic amorphous silicon layer.

In some embodiments of the present application, the silver electrode contains silver powder therein, and the silver powder includes flaky silver powder and spherical silver powder.

In some embodiments of the present application, the first transparent conductive film and the second transparent conductive film are both doped indium oxide films, and dopant elements in the first transparent conductive film and the second transparent conductive film are each independently selected from a group consisting of tin, tungsten, molybdenum, titanium, gallium, zinc, cerium, hydrogen, and any combination thereof.

Furthermore, according to some other embodiments of the present application, a preparation method for a solar cell is further provided. The solar cell includes a cell substrate and a conductive layer. The conductive layer includes a first transparent conductive film, a silver electrode, and a second transparent conductive film. The first transparent conductive film is disposed on a surface of the cell substrate, the silver electrode is disposed on a partial region of the first transparent conductive film, and the second transparent conductive film covers the silver electrode and the first transparent conductive film.

The preparation method for the solar cell includes:
depositing the first transparent conductive film onto the cell substrate;
screen-printing a conductive silver paste on the partial region of the first transparent conductive film and shaping the conductive silver paste to prepare the silver electrode; and
depositing the second transparent conductive film onto a surface of the first transparent conductive film away from the cell substrate.

Furthermore, according to still some embodiments of the present application, a power generation device is further provided. The power generation device includes a solar cell. The solar cell includes a cell substrate and a conductive layer. The conductive layer includes a first transparent conductive film, a silver electrode, and a second transparent conductive film. The first transparent conductive film is disposed on a surface of the cell substrate, the silver electrode is disposed on a partial region of the first transparent conductive film, and the second transparent conductive film covers the silver electrode and the first transparent conductive film.

Details in one or more embodiments of the present application are set forth in the accompanying drawings and the description below. Other features, objectives and advantages of the present application will become apparent from the description, the accompanying drawings, and the claims.

### BRIEF DESCRIPTION OF THE DRAWINGS

FIG. 1 is a schematic structural view of a solar cell according to an embodiment of the present application;
FIG. 2 is a schematic structural view of a conductive layer of the solar cell in FIG. 1; and
FIG. 3 is a scanning electron microscope image of a silver electrode in Comparative Example 1.

Reference numerals in the drawings and their meanings are as follows:
100. cell substrate; 110. silicon substrate layer; 121. front intrinsic amorphous silicon layer; 122. front doped amorphous silicon layer; 131. back intrinsic amorphous silicon layer; 132. back doped amorphous silicon layer; 200. front conductive layer; 210. first front transparent conductive film; 220. front silver electrode; 230. second front transparent conductive film; 300. back conductive layer; 310. first back transparent conductive film; 320. back silver electrode; and 330. second back transparent conductive film.

### DETAILED DESCRIPTION OF THE EMBODIMENTS

To facilitate understanding of the present application, the present application will be described more fully hereinafter. Preferred embodiments of the present application are shown herein. However, the present application can be implemented in various ways and is not limited to the embodiments described herein. Conversely, these embodiments are provided for a more thorough and comprehensive understanding of contented disclosed in the present application.

Unless defined otherwise, all the technical and scientific terms used herein have the same meaning as those commonly understood by those of ordinary skill in the art to which the present invention pertains. The terms used in the description of the present application herein are merely used for describing the specific embodiments and are not intended to limit the present application. As used herein, the term "and/or" includes one or any and all combinations of a plurality of relevant items listed. As used herein, "more" includes two and more than two. As used herein, "a certain number or more" should be understood as a certain number and a range greater than the certain number.

According to an embodiment of the present application, a solar cell is provided, including a cell substrate and a conductive layer. The conductive layer includes a first transparent conductive film, a silver electrode and a second transparent conductive film. The first transparent conductive film is disposed on a surface of the substrate. The silver electrode is disposed on a partial region of the first transparent conductive film. The second transparent film covers the silver electrode and the first transparent conductive film.

In a specific example, the cell substrate of the solar cell includes a silicon substrate layer, an intrinsic amorphous silicon layer, and a doped amorphous silicon layer. The intrinsic amorphous silicon layer is disposed on the silicon substrate layer. The doped amorphous silicon layer is disposed on a surface of the intrinsic amorphous silicon layer away from the silicon substrate layer. The first transparent conductive film is disposed on a surface of the doped amorphous silicon layer away from the intrinsic amorphous silicon layer.

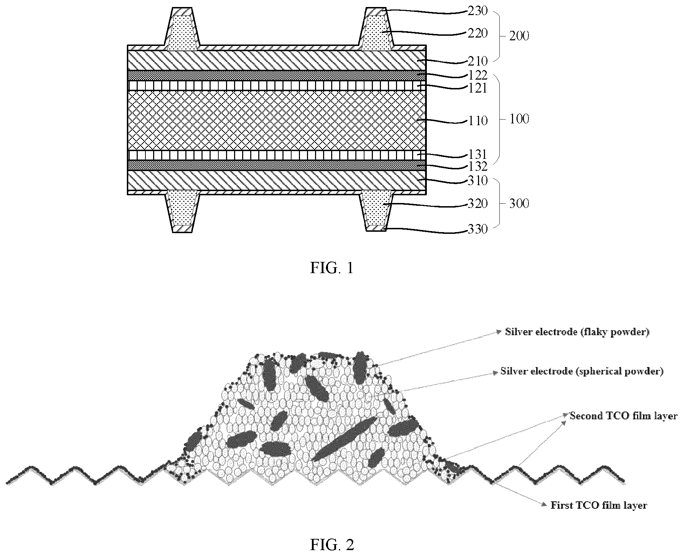

FIG. 1 shows a specific example of the solar cell in the above embodiment. In order to facilitate understanding of the specific structure of the solar cell, reference is made to FIG. 1. The solar cell includes a cell substrate 100 and a conductive layer. It is to be understood that the cell substrate 100 has a front surface and a back surface. In the specific example shown in FIG. 1, both the front surface and the back surface of the cell substrate 100 are provided with the conductive layers, referred to as the front conductive layer 200 and the back conductive layer 300, respectively. The front conductive layer 200 includes a first front transparent conductive film 210, a front silver electrode 220, and a second front transparent conductive film 230. The first front transparent conductive film 210 is disposed on a surface of the cell substrate 100, the front silver electrode 220 is disposed on a partial region of the first front transparent conductive film 210, and the second front transparent conductive film 230 covers the front silver electrode 220 and the first front transparent conductive film 210. The back conductive layer 300 includes a first back transparent conductive film 310, a back silver electrode 320, and a second back transparent conductive film 330. The first back transparent conductive film 310 is disposed on a surface of the cell substrate 100, the back silver electrode 320 is disposed on a partial region of the first back transparent conductive film 310, and the second back transparent conductive film 330 covers the back silver electrode 320 and the first back transparent conductive film 310. In some other specific examples, it is possible to have only the front conductive layer 200 or the back conductive layer 300, both of which can enhance the conductivity of the silver electrode. However, simultaneously incorporating both the front conductive layer 200 and the back conductive layer 300 can significantly improve the fill factor of the overall solar cell. For the sake of clarity, the following description will focus on the front conductive layer 200 as an example to explain the solar cell in FIG. 1. The back conductive layer 300 may not be exactly identical to the front conductive layer 200, but it possesses similar parameters.

The cell substrate 100 includes a silicon substrate layer, an intrinsic amorphous silicon layer, and a doped amorphous silicon layer. In the specific example shown in FIG. 1, both a front surface and a back surface of the silicon substrate layer are provided with the intrinsic amorphous silicon layers and doped amorphous silicon layers, referred to as a front intrinsic amorphous silicon layer 121 and a front doped amorphous silicon layer 122, as well as a back intrinsic amorphous silicon layer 131 and a back doped amorphous silicon layer 132, respectively. The front intrinsic amorphous silicon layer 121 and the front doped amorphous silicon layer 122 are sequentially stacked on the front surface of the silicon substrate layer. The first front transparent conductive film 210 is stacked on the front intrinsic amorphous silicon layer 121. The back intrinsic amorphous silicon layer 131 and the back doped amorphous silicon layer 132 are sequentially stacked on the back surface of the silicon substrate layer. The first back transparent conductive film 310 is stacked on the back intrinsic amorphous silicon layer 131. It is to be understood that a doping type of the front doped amorphous silicon layer 122 is different from that of the back doped amorphous silicon layer 132. For example, in FIG. 1, the doping type of the front doped amorphous silicon layer 122 is n-type, and the doping type of the back doped amorphous silicon layer 132 is p-type. Further, the doping type of a silicon substrate layer 110 is the same as that of the front doped amorphous silicon layer 122.

In the specific example shown in FIG. 1, a total thickness of the first front transparent conductive film 210 and the second front transparent conductive film 230 is 70 nm to 100 nm. The solar cell with this total thickness can maintain substantially the same low reflectivity and substantially the same current density as the solar cell in the conventional art, while also reducing the contact resistance and bulk resistance of the silver electrode. This leads to an increase in both the fill factor and the overall efficiency of the solar cell.

In the specific example shown in FIG. 1, the first front transparent conductive film 210 has a thickness greater than that of the second front transparent conductive film 230. The first front transparent conductive film 210 is primarily used to conduct carriers generated from the cell substrate 100 into the silver electrode. A greater thickness of this film helps reduce its bulk resistance and enhances carrier collection. The second front transparent conductive film is primarily used to fill the pores within the silver electrode and the outer part of the gap between the silver electrode and the first transparent conductive film. An appropriate thickness of this film helps ensure that the entire conductive layer maintains a low reflectivity and a high current density.

In the specific example shown in FIG. 1, the first front transparent conductive film 210 has a thickness of 50 nm to 70 nm. For example, the thickness of the first front transparent conductive film 210 may be 55 nm to 65 nm. Further, the thickness of the first front transparent conductive film 210 may be 55 nm to 60 nm.

In the specific example shown in FIG. 1, the second front transparent conductive film 230 has a thickness of 10 nm to 30 nm. For example, the thickness of the second front transparent conductive film may be 15 nm to 25 nm. Further, the thickness of the second front transparent conductive film may be 20 nm to 25 nm.

In the specific example shown in FIG. 1, the front silver electrode 220 includes silver powder. The front silver electrode 220 may further include an adhesive. The adhesive is used to bond silver powder together and bond the silver powder with the first front transparent conductive film 210. Further, the silver powder includes flaky silver powder and spherical silver powder. A shape of the spherical silver powder may be a regular sphere, a flat ellipsoid or other shapes similar to the regular sphere.

A silver electrode formed by the low-temperature silver paste in the conventional art consists of silver powder particles with gaps between them. As a result, the resistance of the silver electrode, which includes these silver powder particles, is generally high. With reference to FIG. 2, a schematic view of the specific morphology of the front conductive layer 200 in FIG. 1 is shown. It can be found that there are gaps between the silver powder particles within the front silver electrode 220, as well as at the contact interface between the front silver electrode 220 and the first front transparent conductive film 210 underneath the silver electrode. By providing the second transparent conductive film on the surface of the silver electrode, not only the gaps between the silver powder particles can be filled, but also the gap at outer side of the contact interface between the front silver electrode 220 and the first front transparent conductive film 210 can be filled, thereby significantly increasing the conductivity of the entire conductive layer.

In the specific example shown in FIG. 1, the first front transparent conductive film 210 and the second front transparent conductive film 230 are both doped indium oxide film. Dopant elements in the first front transparent conductive film 210 and the second front transparent conductive film 230 are each independently selected from tin, tungsten, molybdenum, titanium, gallium, zinc, cerium, hydrogen, and any combination thereof. Preferably, the first front transparent conductive film 210 and the second front transparent conductive film 230 are made of the same material, for example, tin-doped indium oxide.

Further, the present application also provides a preparation method for the solar cell shown in FIG. 1, which includes steps of: depositing the first transparent conductive film onto the cell substrate; screen-printing a conductive silver paste onto a partial region of the first transparent conductive film and shaping the conductive silver paste to prepare the silver electrode; and depositing the second transparent conductive film onto a surface of the first transparent conductive film away from the cell substrate.

In a specific example of this embodiment, the first transparent conductive film is deposited by a physical vapor deposition method or a rapid plasma deposition method.

In a specific example of this embodiment, the second transparent conductive film is deposited by a physical vapor deposition method or a rapid plasma deposition method.

Specifically, the preparation method for the cell may include S1-S7.

S1, texturing and cleaning the silicon substrate layer. The silicon substrate layer is textured and cleaned to form a textured surface to reduce the reflection of the silicon substrate to lights, which allows more lights to be absorbed, thereby increasing the efficiency of the solar cell. A doping type of the silicon substrate layer is n-type doping.

S2, depositing the front intrinsic amorphous silicon layer onto the front surface of the silicon substrate layer, and depositing the back intrinsic amorphous silicon layer onto the back surface of the silicon substrate layer. Thicknesses of the front intrinsic amorphous silicon layer and the back intrinsic amorphous silicon layer can be controlled in a range of 5 nm to 10 nm by controlling the specific deposition process. The front intrinsic amorphous silicon layer and the back intrinsic amorphous silicon layer can be deposited by a plasma enhanced chemical vapor deposition method.

S3, depositing the front doped amorphous silicon layer onto the front intrinsic amorphous silicon layer, and depositing the back doped amorphous silicon layer onto the back intrinsic amorphous silicon layer. The doping type of the front doped amorphous silicon layer is n-type, and the doping type of the back doped amorphous silicon layer is p-type. The front doped amorphous silicon layer and the back doped amorphous silicon layer can be deposited by a plasma enhanced chemical vapor deposition method. Thicknesses of the front doped amorphous silicon layer and the back doped amorphous silicon layer can be controlled in a range of 5 nm to 10 nm by controlling the specific deposition process.

It is to be understood that through S1-S3, the desired cell substrate can be prepared. Then, the conductive layer needs to be prepared on the cell substrate.

S4, depositing the first front transparent conductive onto the front doped amorphous silicon layer, and depositing the first back transparent conductive film onto the back doped amorphous silicon layer. The first front transparent conductive film and the first back transparent conductive film can be deposited by a physical vapor deposition method. A target may be an indium tin oxide target. Thicknesses of the first front transparent conductive film and the first back transparent conductive film can be controlled in a range of 50 nm to 70 nm by controlling the specific deposition process.

S5, screen-printing a conductive silver paste onto the first front transparent conductive film and shaping the conductive silver paste to prepare the front silver electrode, and screen-printing a conductive silver paste onto the first transparent conductive film and shaping the conductive silver paste to prepare the back silver electrode. The silver electrodes are usually formed only at predetermined regions of the transparent conductive films and are in form of gate lines, which are also referred to as gate line electrodes.

S6, depositing the second front transparent conductive film onto the front silver electrode, and depositing the second back transparent conductive film onto the back silver electrode. The second front transparent conductive film and the second back transparent conductive film can be deposited by a physical vapor deposition method. A target may be an indium tin oxide target. Thicknesses of the second front transparent conductive film and the second back transparent conductive film can be controlled in a range of 10 nm to 30 nm by controlling the specific deposition process. It is to be understood that the conductive layers can be prepared through S4-S6.

In other specific examples, after the second transparent conductive film is prepared, the resulting solar cell may be treated in a light recovery furnace and subjected to performance testing.

A further embodiment of the present application provides a power generation device. The power generation device includes the solar cell of the above embodiments.

The conventional solar cell is prepared by depositing a transparent conductive film onto a cell substrate, followed by screen-printing a silver electrode. The solar cell in the above embodiments includes a redesigned conductive layer on the cell substrate. Specifically, in addition to the first transparent conductive film and the silver electrode provided on the cell substrate, the second transparent conductive film is further applied to the outer surface of the silver electrode. Experimental results have demonstrated that the introduction of the second transparent conductive film does not significantly affect the current density or the reflectivity of the solar cell, and additionally, the gaps between the silver powder on the surface of the silver electrode, as well as the gaps between the silver electrode and the first transparent conductive film, can be filled with an atomic layer of the second transparent conductive film, thereby reducing both the resistance of the silver electrode itself and the contact resistance between the silver electrode and the first transparent conductive film, finally increasing the fill factor of the solar cell.

To facilitate understanding and implementation of the present application, the following specific and detailed example that is easier to implement, along with a comparative example, are provided for reference. The embodiments of the present application and the advantages thereof will also become apparent from the following description of the specific example, the comparative example, and their performance results.

Unless otherwise specified, raw materials used in the following examples can be conventionally purchased from the market.

### Example 1

An N-type monocrystalline silicon wafer with a size of 166 mm and a thickness of 150 µm, as a silicon substrate layer, was textured and cleaned to obtain a texture surface has a size of 2 µm to 6 µm and light reflectivity of 8% to 11%.

A front intrinsic amorphous silicon layer and a back intrinsic amorphous silicon layer were respectively prepared onto a front surface and a back surface of the silicon substrate layer by a plasma enhanced chemical vapor deposition method, with thicknesses thereof controlled in a range of 5 nm to 10 nm.

An n-type amorphous silicon layer and a p-type amorphous silicon layer were respectively deposited onto the front surface and the back surface by a plasma enhanced chemical vapor deposition, with thicknesses thereof controlled in a range of 5 nm to 10 nm.

A first front transparent conductive film layer was deposited onto the front surface by a physical vapor deposition method, with a thickness thereof controlled in a range of 55 nm to 60 nm, and a first back transparent conductive film layer was deposited onto the back surface by a physical vapor deposition method, with a thickness thereof controlled in a range of 55 nm to 60 nm.

A low-temperature silver paste was printed onto the back surface by screen-printing and solidified to form a front silver electrode and a back silver electrode.

A second front transparent conductive film layer was deposited on the front surface by a physical vapor deposition method, with a thickness thereof controlled in a range of 20 nm to 25 nm, and a second back transparent conductive film layer was deposited on the back surface by a physical vapor deposition method, with a thickness thereof controlled in a range of 20 nm to 25 nm.

### Comparative Example 1

An N-type monocrystalline silicon wafer with a size of 166 mm and a thickness of 150 µm, as a silicon substrate layer, was textured and cleaned to obtain a texture surface has a size of 2 µm to 6 µm and a light reflectivity of 8% to 11%.

A front intrinsic amorphous silicon layer and a back intrinsic amorphous silicon layer were respectively prepared onto a front surface and a back surface of the silicon substrate layer by a plasma enhanced chemical vapor deposition method, with thicknesses thereof controlled in a range of 5 nm to 10 nm.

An n-type amorphous silicon layer and a p-type amorphous silicon layer were respectively deposited onto the front surface and the back surface by a plasma enhanced chemical vapor deposition, with thicknesses thereof controlled in a range of 5 nm to 10 nm.

A front transparent conductive film layer was deposited onto the front surface by a physical vapor deposition method, with a thickness thereof controlled in a range of 75 nm to 85 nm, and a back transparent conductive film layer was deposited onto the back surface by a physical vapor deposition method, with a thickness thereof controlled in a range of 75 nm to 85 nm.

A low-temperature silver paste was printed onto the back surface by screen-printing and solidified to form a front silver electrode and a back silver electrode.

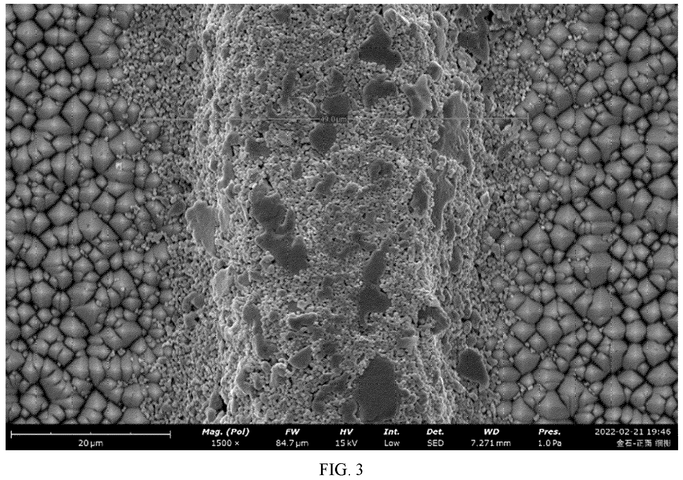

A schematic view of the silver electrode formed by screen-printing in Comparative Example 1 is shown in FIG. 3. It is evident from FIG. 3 that the silver electrode formed by the low-temperature silver paste consists of an accumulation of silver powder particles, including both spherical silver powder particles and flaky silver powder particles. The presence of gaps between these particles results in the resistance of the silver electrode formed with low-temperature silver paste being more than three times greater than that of the silver electrode formed with high-temperature silver paste.

Test Example: the solar cells prepared in Example 1 and Comparative Example 1 were placed into a light recovery furnace, and then tested for contact resistance Rₛ, open circuit voltage V_{oc}, short circuit current I_{sc}, fill factor FF and conversion efficiency Eₜₐ. The contact resistance is resistance of the entire cell. The results are shown in Table 1.

**Table 1**

| | V_{oc} (mV) | I_{sc} (mA/cm²) | Rₛ (mQ) | FF (%) | Eta (%) |
|---|---|---|---|---|---|
| Example 1 | 744.4 | 38.46 | 1.68 | 84.75 | 24.263 |
| Comparative Example 1 | 744.5 | 38.54 | 2.04 | 84.21 | 24.162 |

It can be seen from Table 1 that there is no significant difference in the open circuit voltage between Example 1 and Comparative Example 1, while there is a slight decrease in the current density, indicating that dual deposition of the transparent conductive film layers and the application of the silver electrode between transparent conductive film layers, as in Example 1, do not lead to significant changes in the open circuit voltage and short circuit current of the solar cell compared to Comparative Example 1. Moreover, the contact resistance of the solar cell of Example 1 is reduced by 0.36 mΩ, representing a reduction of 17.6% compared to Comparative Example 1. Since the contact resistance includes not only the resistance of the grid line itself, but also the resistance of the silicon wafer in the cell, the actual reduction in the resistance of the grid line itself is higher than 17.6%, indicating that the design of the conductive layer in Example 1 significantly reduces the contact resistance of the solar cell. Additionally, due to the decrease in contact resistance, the solar cell in Example 1 exhibits an increase in fill factor by 0.54% and an increase in conversion efficiency by 0.101% compared to Comparative Example 1. This demonstrates that the solar cell in Example 1 effectively enhances the conductivity between the grid line electrode formed by low-temperature silver paste and the transparent conductive film, thereby increasing the conversion efficiency of the solar cell.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, comprising a cell substrate and a conductive layer, wherein the conductive layer comprises a first transparent conductive film, a silver electrode and a second transparent conductive film, the first transparent conductive film is disposed on a surface of the cell substrate, the silver electrode is disposed on a partial region of the first transparent conductive film, and the second transparent conductive film covers the silver electrode and the first transparent conductive film.

2. The solar cell according to claim **1,** wherein a total thickness of the first transparent conductive film and the second transparent conductive film is 70 nm to 100 nm.

3. The solar cell according to claim 2, wherein the first transparent conductive film has a thickness greater than that of the second transparent conductive film .

4. The solar cell according to claim 3, wherein the first transparent conductive film has a thickness of 50 nm to 70 nm.

5. The solar cell according to claim 3, wherein the second transparent conductive film has a thickness of 10 nm to 30 nm.

6. The solar cell according to any one of claims 1 to 5, wherein the silver electrode contains silver powder therein, and the silver powder comprises flaky silver powder and spherical silver powder.

7. The solar cell according to any one of claims 1 to 5, wherein the cell substrate comprises a silicon substrate layer, an intrinsic amorphous silicon layer, and a doped amorphous silicon layer, the intrinsic amorphous silicon layer is disposed on the silicon substrate layer, the doped amorphous silicon layer is disposed on a surface of the intrinsic amorphous silicon layer away from the silicon substrate layer, and the first transparent conductive film is disposed on a surface of the doped amorphous silicon layer away from the intrinsic amorphous silicon layer.

8. The solar cell according to any one of claims 1 to 5, wherein the first transparent conductive film and the second transparent conductive film are both doped indium oxide films, and dopant elements in the first transparent conductive film and the second transparent conductive film are each independently selected from a group consisting of tin, tungsten, molybdenum, titanium, gallium, zinc, cerium, hydrogen, and any combination thereof.

9. A preparation method for a solar cell, wherein the solar cell comprises a cell substrate and a conductive layer, the conductive layer comprises a first transparent conductive film, a silver electrode and a second transparent conductive film, the first transparent conductive film is disposed on a surface of the cell substrate, the silver electrode is disposed on a partial region of the first transparent conductive film, and the second transparent conductive film covers the silver electrode and the first transparent conductive film; and the preparation method for the solar cell comprises:
depositing the first transparent conductive film onto the cell substrate;
screen-printing a conductive silver paste onto the partial region of the first transparent conductive film and shaping the conductive silver paste to prepare the silver electrode; and
depositing the second transparent conductive film on a surface of the first transparent conductive film away from the cell substrate.

10. The preparation method for the solar cell according to claim 9, wherein a total thickness of the first transparent conductive film and the second transparent conductive film is 70 nm to 100 nm.

11. The solar cell according to claim 10, wherein the first transparent conductive film has a thickness greater than that of the second transparent conductive film.

12. The preparation method for the solar cell according to claim 11, wherein the first transparent conductive film has a thickness of 50 nm to 70 nm.

13. The preparation method for the solar cell according to claim 11, wherein the second transparent conductive film has a thickness of 10 nm to 30 nm.

14. The preparation method for the solar cell according to any one of claims 9 to 13, wherein the silver electrode contains silver powder therein, and the silver powder comprises flaky silver powder and spherical silver powder.

15. The preparation method for the solar cell according to any one of claims 9 to 13, wherein the cell substrate comprises a silicon substrate layer, an intrinsic amorphous silicon layer, and a doped amorphous silicon layer, the intrinsic amorphous silicon layer is disposed on the silicon substrate layer, the doped amorphous silicon layer is disposed on a surface of the intrinsic amorphous silicon layer away from the silicon substrate layer, and the first transparent conductive film is disposed on a surface of the doped amorphous silicon layer away from the intrinsic amorphous silicon layer.

16. The preparation method for the solar cell according to any one of claims 9 to 13, wherein the first transparent conductive film and the second transparent conductive film are both doped indium oxide films, and dopant elements in the first transparent conductive film and the second transparent conductive film are each independently selected from a group consisting of tin, tungsten, molybdenum, titanium, gallium, zinc, cerium, hydrogen, and any combination thereof.

17. The preparation method for the solar cell according to any one of claims 9 to 16, wherein the first transparent conductive film is deposited by a physical vapor deposition method or a rapid plasma deposition method.

18. The preparation method for a solar cell according to any one of claims 9 to 16, wherein the second transparent conductive film is deposited by a physical vapor deposition method or a rapid plasma deposition method.

19. A power generation device, comprising a solar cell, wherein the solar cell comprises a cell substrate and a conductive layer, the conductive layer comprises a first transparent conductive film, a silver electrode, and a second transparent conductive film, the first transparent conductive film is disposed on a surface of the cell substrate, the silver electrode is disposed on a partial region of the first transparent conductive film, and the second transparent conductive film covers the silver electrode and the first transparent conductive film.

20. The solar cell according to claim 19, wherein a total thickness of the first transparent conductive film and the second transparent conductive film is 70 nm to 100 nm.

21. The solar cell according to claim 20, wherein the first transparent conductive film has a thickness greater than that of the second transparent conductive film.

22. The solar cell according to claim 21, wherein the first transparent conductive film has a thickness of 50 nm to 70 nm.

23. The solar cell according to claim 21, wherein the second transparent conductive film has a thickness of 10 nm to 30 nm.

24. The solar cell according to any one of claims 19 to 23, wherein the silver electrode contains silver powder therein, and the silver powder comprises flaky silver powder and spherical silver powder.

25. The solar cell according to any one of claims 19 to 23, wherein the cell substrate comprises a silicon substrate layer, an intrinsic amorphous silicon layer, and a doped amorphous silicon layer, the intrinsic amorphous silicon layer is disposed on the silicon substrate layer, the doped amorphous silicon layer is disposed on a surface of the intrinsic amorphous silicon layer away from the silicon substrate layer, and the first transparent conductive film is disposed on a surface of the doped amorphous silicon layer away from the intrinsic amorphous silicon layer.

26. The solar cell according to any one of claims 19 to 23, wherein the first transparent conductive film and the second transparent conductive film are both doped indium oxide films, and dopant elements in the first transparent conductive film and the second transparent conductive film are each independently selected from a group consisting of tin, tungsten, molybdenum, titanium, gallium, zinc, cerium, hydrogen, and any combination thereof.
